# EUROPÄISCHE PATENTSCHRIFT

(11) **EP 2 136 419 B1**
(45) Veröffentlichungstag und Bekanntmachung des Hinweises auf die Patenterteilung: **13.08.2014**
(21) Anmeldenummer: 09163119.2
(22) Anmeldetag: 18.06.2009
(51) Int. Cl.: H01L 41/083, H01L 41/27

(54) **Vielschichtaktor sowie Verfahren zum Herstellen eines Vielschichtaktors**
Multilayer actuator and method for producing same
Actionneur multicouche et procédé de fabrication d'un actionneur multicouche

(30) Priorität: 18.06.2008 DE 102008002489
(43) Veröffentlichungstag der Anmeldung: 23.12.2009
(73) Patentinhaber: Robert Bosch GmbH, 70469 Stuttgart (DE)
(72) Erfinder: Polster, Steffen, 70199, Stuttgart (DE); Schwegler, Leonore, 70374, Stuttgart (DE); Hagemann, Benjamin, 70839, Gerlingen (DE)

(56) Entgegenhaltungen:
- WO-A2-2006/123317
- RANDAZZO M ET AL: "Architecture for the semi-automatic fabrication and assembly of thin-film based dielectric elastomer actuators", ELECTROACTIVE POLYMER ACTUATORS AND DEVICES (EAPAD), 10 MARCH 2008, SAN DIEGO, CA, USA; PROCEEDINGS OF THE SPIE, Bd. 6927, 27. März 2008 (2008-03-27), Seiten 69272D/1-10, XP002536275, ISSN: 0277-786X
- SCHLAAK H F ET AL: "Novel multilayer electrostatic solid-state actuators with elastic dielectric", ELECTROACTIVE POLYMER ACTUATORS AND DEVICES (EAPAD), 7 MARCH 2005, SAN DIEGO, CA, USA; PROCEEDINGS OF THE SPIE, Bd. 5759, Nr. 1, 2005, Seiten 121-133, XP002536274, ISSN: 0277-786X

## Beschreibung

### Stand der Technik

Die Erfindung betrifft einen Vielschichtaktor gemäß dem Oberbegriff des Anspruchs 1 sowie ein Verfahren zum Herstellen eines Vielschichtaktors gemäß dem Oberbegriff des Anspruchs 8.

Vielschichtaktoren, umfassend mehrere Schichten aus einem elektroaktiven Polymer mit zwischen den Schichten angeordneten Elektroden sind bekannt. Das Anlegen einer elektrischen Spannung an die Elektroden führt aufgrund der elektrostatischen Anziehung zwischen den Elektroden und der Verwendung eines verformbaren Dielektrikums zu einer Kontraktion in Stapelrichtung des Aktors bei einer entsprechenden Ausdehnung in die anderen beiden Raumrichtungen, wobei das elektroaktive, zwischen den Elektroden angeordnete, Polymer bei seiner Deformation volumenkonstant bleibt. Die Längskontraktion kann aufgrund der nicht optimalen mechanischen Anbindung zwischen den einzelnen Aktorlagen nur in Grenzen direkt genutzt werden. Ein entsprechend dem derzeitigen Stand der Technik aufgebauter, auf Zug belasteter Vielschichtaktor delaminiert dabei sehr leicht. Deshalb werden bekannte Vielschichtaktoren typischerweise auf Druck belastet.

Die WO 2006/123317 A2 offenbart ein dielektrisches elektroaktives Polymer mit Elastomer-Elektroden.

### Offenbarung der Erfindung

### Technische Aufgabe

Der Erfindung liegt daher die Aufgabe zugrunde, einen Vielschichtaktor vorzuschlagen, bei dem Delaminationserscheinungen, insbesondere bei Belastung auf Zug, vermieden werden. Ferner besteht die Aufgabe darin, ein entsprechendes Herstellungsverfahren für einen derartig optimierten Vielschichtaktor vorzuschlagen.

### Technische Lösung

Diese Aufgabe wird hinsichtlich des Vielschichtaktors mit den Merkmalen des Anspruchs 1 und hinsichtlich des Herstellungsverfahrens mit den Merkmalen des Anspruchs 8 gelöst. Vorteilhafte Weiterbildungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen. Zur Vermeidung von Wiederholungen sollen verfahrensgemäß offenbarte Merkmale auch als vorrichtungsgemäß offenbart gelten und beanspruchbar sein. Ebenso sollen vorrichtungsgemäß offenbarte Merkmale als verfahrensgemäß offenbart gelten und beanspruchbar sein.

Der Erfindung liegt der Gedanke zugrunde, die Stabilität des Vielschichtaktors dadurch zu erhöhen, dass mindestens zwei benachbarte Schichten des Schichtaufbaus des Vielschichtaktors, zumindest abschnittsweise, miteinander vernetzt sind. Anders ausgedrückt sollen Delaminationseffekte dadurch vermieden werden, dass die deformierbaren Schichten, sofern diese in Abschnitten unmittelbar aneinander anliegen, miteinander vernetzt sind und/oder dadurch, dass die Elektrodenschicht mit zumindest einer der deformierbaren Schichten, vorzugsweise mit beiden an die Elektrodenschicht angrenzenden deformierbaren Schichten, vernetzt ist. Bevorzugt handelt es sich bei der Vernetzung um eine chemische Verkettung der jeweiligen Schichtmaterialien untereinander. Insbesondere dann, wenn sämtliche aneinander angrenzende, vorzugsweise, zumindest näherungsweise, parallel zueinander angeordnete, Schichten des Vielschichtaktors miteinander chemisch vernetzt sind, wird ein monolithischer Vielschichtaktor erhalten, der gegenüber den aus dem Stand der Technik bekannten Vielschichtaktoren eine deutlich gesteigerte Zugfestigkeit aufweist. Durch die Vernetzung von zumindest zwei aneinander angrenzenden Schichten ist ein nach dem Konzept der Erfindung ausgebildeter Vielschichtaktor besonders geeignet, Zugspannungen in Längsrichtung aufnehmen zu können, wodurch die bei entsprechender Bestromung des Vielschichtaktors auftretende Verkürzung direkt nutzbar wird.

Es ist realisierbar, dass die deformierbare Schicht und/oder die Elektrodenschicht aus mindestens zwei Komponenten gebildet wird, von denen mindestens eine, vorzugsweise ausschließlich eine, vernetzbar ist. Zusätzlich oder alternativ können in die vorgenannte deformierbare Schicht Füllmaterialien zum Beeinflussen der dielektrischen Eigenschaften eingebracht werden.

Im Hinblick auf die Art und Weise der Vernetzung bzw. der Realisierung einer Vernetzungsreaktion gibt es unterschiedlichste Möglichkeiten. Gemäß einer besonders bevorzugten Ausführungsform erfolgt die vollständige Vernetzung von schon teilvernetzten Schichten des Vielschichtaktors nach dem Stapeln bzw. Falten, vorzugsweise photoinitiiert. Bei einer besonders bevorzugten Ausführungsform erhält der Vielschichtaktor durch eine Polymerisationsreaktion eine durchgängige Polymermatrix, wodurch ein besonders belastbarer Vielschichtaktor erhalten wird. Alternativ zu einer Polymerisation kann die Verkettung der Schichtmaterialien beispielsweise durch eine Polykondensations- oder Polyadditions- oder Vulkanisationsreaktion erfolgen. Wesentlich ist, dass sich Makromoleküle bilden und dass sich unter den Schichten ein miteinander vernetztes Geflecht bildet.

Im Hinblick auf die Materialwahl für die deformierbaren Schichten und die Elektrodenschicht gibt es ebenfalls unterschiedliche Möglichkeiten. Besonders bevorzugt ist eine Ausführungsform, bei der die die mindestens eine Elektrodenschicht zwischen sich aufnehmenden, deformierbaren Schichten aus dem gleichen Material ausgebildet sind - es ist jedoch auch eine Ausführungsform mit unterschiedlichen Materialien realisierbar, insbesondere dann, wenn die Materialien fähig sind, insbesondere in einer chemischen Verkettungsreaktion miteinander zu reagieren. Auch ist es bevorzugt, wenn das Material der Elektrodenschicht geeignet ist, mit dem Material zumindest einer der deformierbaren Schichten chemisch zu vernetzen. Dabei ist es besonders bevorzugt, wenn zwei unmittelbar aneinander angrenzende Schichten in ihrem gesamten Anlagebereich vollflächig miteinander vernetzt sind, um somit eine optimale Kraftübertragung zwischen den einzelnen Schichten zu gewährleisten.

In Weiterbildung der Erfindung ist mit Vorteil vorgesehen, dass abschnittsweise aneinander anliegende, deformierbare Schichten in einem Anlagebereich außerhalb der Elektrodenschicht miteinander vernetzt sind. Dabei ist eine Ausführungsform realisierbar, bei der die zwischen den miteinander vernetzten, deformierbaren Schichten aufgenommene Elektrodenschicht nicht mit den benachbarten deformierbaren Schichten vernetzt ist. Besonders bevorzugt ist jedoch eine Ausführungsform, bei der auch die Elektrodenschicht mit den benachbarten Schichten vernetzt ist. Dies ist insbesondere dann von Vorteil bzw. notwendig, wenn die die Elektrodenschicht zwischen sich aufnehmenden deformierbaren Schichten nicht unmittelbar aneinander anliegen, sondern die einander zugewandten Seiten der deformierbaren Schichten vollständig mit einer zwischen den deformierbaren Schichten aufgenommenen Elektrodenschicht bedeckt sind.

Im Hinblick auf die Realisierung einer Vernetzung der Elektrodenschicht mit den benachbarten deformierbaren Schichten ist eine Ausführungsform bevorzugt, bei der die Elektrodenschicht aus einem vernetzbaren, insbesondere polymerisierbaren, dielektrischen Material besteht, vorzugsweise aus dem gleichen Material wie die deformierbaren Schichten, wobei zur Realisierung einer Elektrodenfunktion bzw. zur Realisierung einer elektrischen Leitfähigkeit in dieses deformierbare Material der Elektrodenschicht elektrisch leitende Partikel eingearbeitet sind. Besonders bevorzugt handelt es sich bei diesen elektrisch leitenden Partikeln um Kohlenstoffpartikel (alternativ: leitfähiges Polymer oder Carbonnanotubes).

Wie eingangs angedeutet, gibt es die unterschiedlichsten Möglichkeiten zur Herstellung eines monolithischen Vielschichtaktors. So ist es beispielsweise möglich, mindestens einen Elektrodenstreifen, umfassend mindestens eine deformierbare, elektrische Schicht mit darauf aufgebrachter Elektrodenschicht mit Hilfe einer so genannten Falttechnik zu einem Vielschichtaktor zu falten. Dabei ist es besonders bevorzugt, wenn dieser zu faltende Elektrodenstreifen vor dem Faltprozess teilvernetzt, d. h. noch nicht vollständig vernetzt, ist, so dass in einem abschließenden Ausvernetzungsschritt bei fertig gefaltetem Vielschichtaktor ein monolithischer, durchgehend vernetzter, Aufbau realisierbar ist. Bevorzugt ist der gefaltete Elektrodenstreifen beidseitig mit einer Elektrodenschicht versehen. Dies kann beispielsweise dadurch realisiert werden, dass eine teilvernetzte Schicht aus einem deformierbaren, dielektrischen Material mit einer mit Kohlenstoffpartikeln gefüllten, insbesondere vor dem Falten teilvernetzten, Polymerschicht bedruckt oder besprüht ist. Nach Abschluss der Faltung aller Schichten wird der so entstandene Faltaktor durchvernetzt. Analog kann der Vielschichtaktor beispielsweise in einer an sich bekannten Stapeltechnik aufgebaut werden, wobei die zu stapelnden Schichten bevorzugt teilvernetzt sind und nach dem Stapeln in einem abschließenden Ausvernetzungsschritt durchvernetzt werden. Alternativ ist es möglich, den Vielschichtaktor in einer Sprüh- und/oder Drucktechnik herzustellen, wobei die einzelnen Schichten des Vielschichtaktors aufeinander gesprüht werden. Dabei kann nach jedem Aufbringen einer Schicht ein Vernetzungsschritt durchgeführt werden, der die soeben aufgebrachte, noch fluide Schicht mit der zuvor aufgebrachten Schicht vernetzt. Dabei wird eine zum Auslösen und/oder Aufrechterhalten der Vernetzungsreaktion eingesetzte Bestrahlung bevorzugt derart dosiert, dass die zuletzt aufgebrachte Schicht (noch nicht) vollständig ausvernetzt wird, um eine Vernetzungsreaktion mit der nachfolgenden, also noch aufzusprühenden und/oder aufzudruckenden, Schicht möglich ist.

Um die Stabilität des Vielschichtaktors weiter zu erhöhen und um elektrische Kurzschlussreaktionen durch eine versehentliche Fehlkontaktierung der Elektrodenschichten zu vermeiden, ist eine Ausführungsform bevorzugt, bei der die nebeneinander angeordneten Schichten (deformierbare, dielektrische Schichten und die Elektrodenschichten) in einer Hülle aus vernetzbarem, deformierbarem, dielektrischem Material aufgenommen sind, wobei es besonders bevorzugt ist, wenn diese Hülle mit den Schichten vernetzt ist.

Erfindungsgemäß ist das vernetzbare Material der deformierbaren Schichten und/oder das vernetzbare Material der, insbesondere ebenfalls deformierbaren, Elektrodenschichten strahlenvernetzbar. Zur Realisierung der Vernetzungsreaktion kann die Schichtanordnung beispielsweise mit UV-Licht bestrahlt werden, wobei es in diesem Fall notwendig ist, dass das vernetzbare Material Photoinitiatoren enthält. Zusätzlich oder alternativ kann die Vernetzungsreaktion durch Elektronenstrahlung ausgelöst werden, wobei in diesem Fall mit Vorteil auf Photoinitiatoren verzichtet werden kann.

Besonders bevorzugt ist eine Ausführungsform des Vielschichtaktors, bei der an die zuvor beschriebene Schichtanordnung, umfassend eine zwischen zwei deformierbaren Schichten aufgenommene Elektrodenschicht, weitere Schichten anschließen, wobei auch hier bevorzugt jeweils zwei unmittelbar aneinander angrenzende Schichten, vorzugsweise vollflächig, miteinander vernetzt sind. Bevorzugt ergibt sich dabei ein Aufbau des Vielschichtaktors aus alternierend angeordneten, deformierbaren Schichten und Elektrodenschichten. Es ist auch möglich, unmittelbar zwei deformierbare Schichten aus einem dielektrischen Material nebeneinander anzuordnen und miteinander zu vernetzen sowie unmittelbar zwei, eine gemeinsame Elektrodenschicht bildende, Teil-Elektrodenschichten.

Die Erfindung führt auch auf ein Verfahren zum Herstellen eines Vielschichtaktors. Dabei wird ein Schichtaufbau realisiert, der mindestens eine zwischen zwei deformierbaren, dielektrischen Schichten aufgenommene Elektrodenschicht umfasst. Die Realisierung eines derartigen Schichtaufbaus kann in an sich bekannter Weise durch Stapeln und/oder Falten erfolgen. Es ist auch möglich, die einzelnen Schichten, zumindest zum Teil, durch Sprühen und/oder Drucken aufeinander aufzubringen. Wesentlich ist, dass die deformierbaren Schichten miteinander und/oder die Elektrodenschicht mit zumindest einer der deformierbaren, vorzugsweise mit beiden an diese angrenzenden deformierbaren, Schichten strahlenvernetzt wird, insbesondere in einer Polymerisations-, Polykondensations- oder Vulkanisationsreaktion. Dabei kann die durchgängige Vernetzung in einem abschließenden Strahlen-Vernetzungsreaktionsschritt erfolgen oder in Teilschritten, insbesondere nach dem Schichten einer bestimmten Anzahl von Schichten.

Besonders bevorzugt ist eine Ausführungsform des Verfahrens, insbesondere dann, wenn der Schichtaufbau durch Stapeln oder Falten hergestellt wird, bei der die zu stapelnden Schichten bzw. der zu faltende Elektrodenstreifen vor dem Stapeln bzw. Falten teilvernetzt wird, also (noch) nicht vollständig, um eine abschließende durchgehende Vernetzungsreaktion zu ermöglichen.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1:: einen schematischen Aufbau eines monolithischen Vielschichtaktors,
- Fig. 2:: in einer schematischen Darstellung einen Herstellungsablauf zur Herstellung eines alternativen monolithischen Vielschichtaktors, und
- Fig. 3:: in einer schematischen Darstellung ein Zwischenstadium bei der Herstellung eines alternativen Vielschichtaktors mit bis an den Aktorrand reichenden Elektrodenschichten.

### Ausführungsformen der Erfindung

In den Figuren sind gleiche Bauteile und Bauteile mit der gleichen Funktion mit den gleichen Bezugszeichen gekennzeichnet.

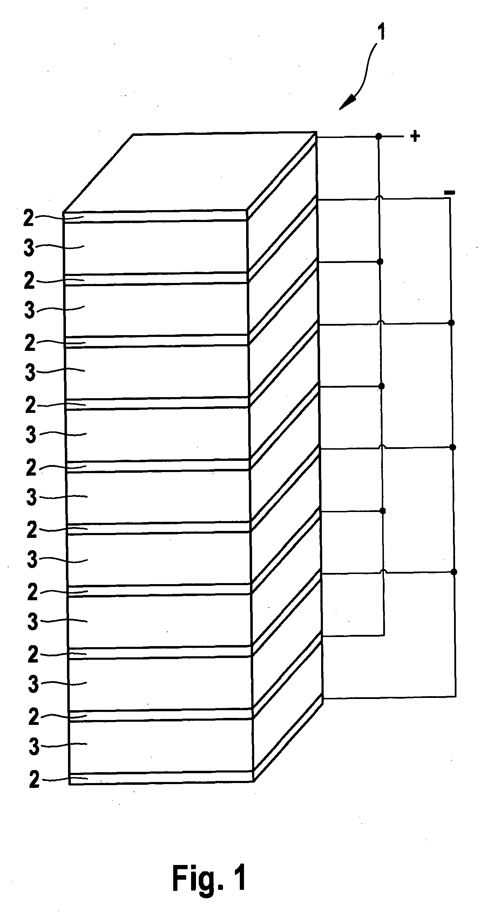

In Fig. 1 ist ein Vielschichtaktor 1 gezeigt. Dieser umfasst alternierend angeordnete Elektrodenschichten 2 und deformierbare Schichten 3 aus einem dielektrischen, elastisch verformbaren Material. Es ergibt sich also ein Schichtaufbau, bei dem eine Elektrodenschicht 2 jeweils zwischen zwei deformierbaren Schichten 3 aufgenommen ist, wobei auch die Elektrodenschichten 2 selbst volumenkonstant deformierbar sind.

In dem gezeigten Ausführungsbeispiel liegen jeweils zwei an eine Elektrodenschicht 2 angrenzende deformierbare Schichten 3 an keiner Stelle unmittelbar aneinander an, da die Elektrodenschicht 2 die gleiche Flächenerstreckung hat wie die benachbarten deformierbaren Schichten 3.

Bei dem in Fig. 1 gezeigten Vielschichtaktor 1 handelt es sich um einen monolithischen Vielschichtaktor 1, bei dem sämtliche unmittelbar aneinander angrenzende Schichten 2, 3 vollflächig miteinander vernetzt sind. Hierzu wurden die Elektrodenschichten 2 als auch die deformierbaren Schichten 3 aus einem strahlenvernetzbaren Material, beispielsweise einem Prepolymer, aufgebaut, wobei die Elektrodenschichten 2 und die deformierbaren Schichten 3 nach der Herstellung des in Fig. 1 gezeigten Schichtaufbaus in einer Vernetzungsreaktion durchgehend vernetzt wurden. Bevorzugt sind dabei sowohl die Elektrodenschichten 2 als auch die deformierbaren, dielektrischen Schichten 3 aus einem Polymer, beispielsweise Silikon oder Acryl, hergestellt, wobei die Schichtdicke der einzelnen Schichten bevorzugt in einem Bereich zwischen etwa 1 µm und etwa 1000 µm, vorzugsweise 2 µm bis 250 µm, bevorzugt 4 µm bis 50 µm, liegt. Die abschließende Durchvernetzungsreaktion wird bevorzugt durch Beaufschlagen des Schichtaufbaus mit UV-Strahlung ausgelöst, wobei hierzu sowohl in den Elektrodenschichten 2 als auch in den deformierbaren Schichten 3 Photoinitiatoren vorgesehen sind. Die UV-Bestrahlung erfolgt bevorzugt in einem für UV-Strahlung transparenten Hilfswerkzeug. Alternativ ist eine Bestrahlung mit Elektronenstrahlen möglich.

Ein wie zuvor beschrieben aufgebauter Vielschichtaktor 1 ist besonders gut auf Zug belastbar. Werden die Elektrodenschichten 2, wie aus Fig. 1 hervorgeht, bestromt, wird also an jeweils zwei benachbarte Elektrodenschichten 2 eine Spannung angelegt und es resultiert aus der elektrostatischen Anziehung der Elektrodenschichten 2 eine Kontraktion des Vielschichtaktors 1. Dabei verformen sich die deformierbaren Schichten 3 sowie die Elektrodenschichten 2 in beide Raumrichtungen quer zur Kontraktionsrichtung volumenkonstant.

Die Elektrodenschichten 2 unterscheiden sich vom Aufbau der deformierbaren Schichten 3 insbesondere dadurch, dass sie zum einen eine geringere Dickenerstreckung in Stapelrichtung aufweisen und zum anderen elektrisch leitende Partikel umfassen, die erst die Elektrodenfunktion gewährleisten.

Ein in Fig. 1 gezeigter Vielschichtaktor 1 kann dadurch weiter optimiert werden, dass der gezeigte Schichtaufbau in einer Hülle aus vernetzbarem Material aufgenommen ist, wobei die Hülle mit den Seitenflächen der Elektrodenschichten 2 und der deformierbaren Schichten 3 vernetzt ist, um eine optimale Stabilität zu erhalten.

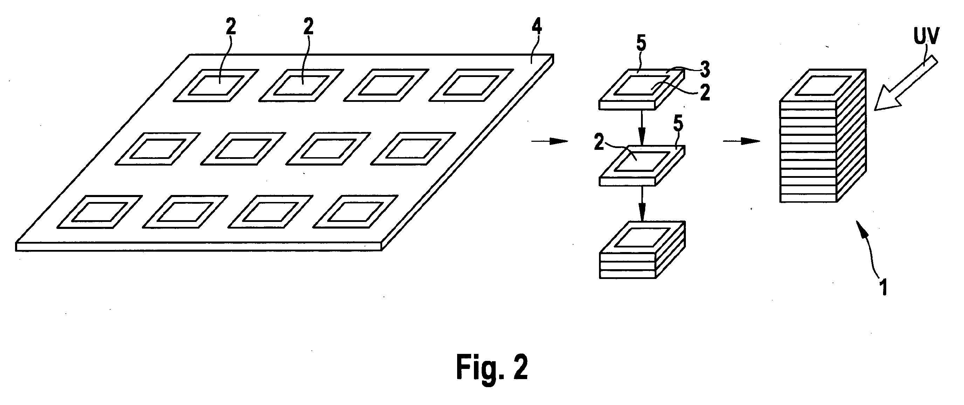

In Fig. 2 ist schematisch ein mögliches Herstellungsverfahren zum Herstellen eines Vielschichtaktors 1 gezeigt. Zu erkennen ist in der Zeichnungsebene links eine plattenförmige Folie 4 aus einem deformierbaren, dielektrischen Material. Auf diese sind eine Vielzahl von nebeneinander angeordneten Elektrodenschichten 2 aufgedruckt, wobei die Elektrodenschichten 2 aus einem deformierbaren, vernetzbaren Material, das mit elektrisch leitenden Partikeln vermischt ist, gebildet sind. Nach einer Teilvernetzungsreaktion werden aus der Folie 4 einzelne Schichtkombinationen 5 ausgestanzt, wobei jede Schichtkombination 5 eine deformierbare, dielektrische Schicht 3 (Zwischenschicht) sowie eine auf diese aufgebrachte Elektrodenschicht 2 umfassen. Die Schichtkombinationen 5 werden, wie sich aus der mittleren Darstellung gemäß Fig. 2 ergibt, nebeneinander, hier in Hochrichtung, gestapelt. Nach Fertigstellung des aus der Zeichnungsebene rechts ersichtlichen Schichtaufbaus wird eine Bestrahlung mit UV-Strahlung vorgenommen, wodurch jeweils benachbarte Schichtkombinationen 5 miteinander sowie die Elektrodenschichten 2 und die deformierbaren Schichten 3 jeder Schichtkombination 5 untereinander durchvernetzt werden, so dass in Summe ein monolithisch aufgebauter Vielschichtaktor 1 erhalten wird.

Aus Fig. 2 ist zu erkennen, dass im Gegensatz zu dem Ausführungsbeispiel gemäß Fig. 1 zwei in Stapelrichtung benachbarte deformierbare Schichten 3 in einem Bereich außerhalb der Elektrodenschichten 2 unmittelbar aneinander anliegen - es sind also nicht nur die Elektrodenschichten 2 mit den benachbarten deformierbaren Schichten 3, sondern auch jeweils zwei benachbarte deformierbare Schichten 3 untereinander durchvernetzt. Auch der in Fig. 2 gezeigte Vielschichtaktor 1 kann bei Bedarf in einer Hülle aus vernetzbarem Material aufgenommen werden, wobei die Hülle bevorzugt mit dem Schichtaufbau vernetzt ist.

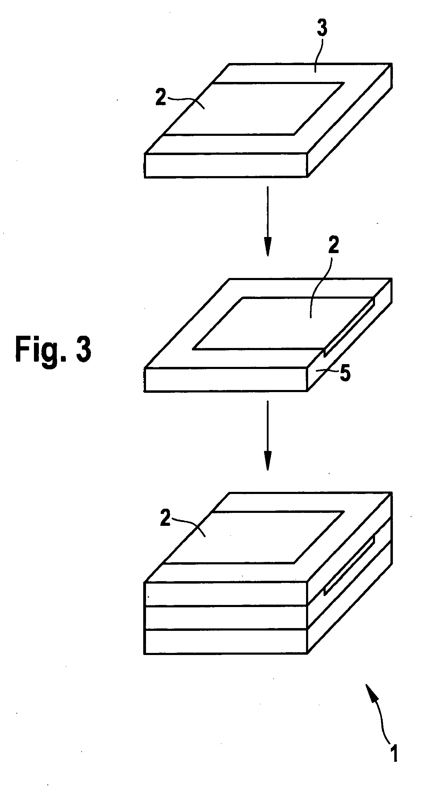

In Fig. 3 ist ein Zwischenstadium bei der Herstellung eines alternativen Vielschichtaktors 1 gezeigt. Zu erkennen ist, dass die Elektrodenschichten 2 alternierend an zwei voneinander abgewandten Randseiten des Vielschicktaktors geführt sind, um zusammengehörige Elektrodenschichten (gleiches Potential), insbesondere mittels einer nicht gezeigten, sich in Stapelrichtung erstreckenden Sammelelektrode, elektrisch kontaktieren zu können.

## Patentansprüche

1. Vielschichtaktor mit mindestens einer Elektrodenschicht (2), die zwischen zwei deformierbaren Schichten (3), umfassend ein dielektrisches, vernetzbares Material, angeordnet ist, wobei die deformierbaren Schichten (3) miteinander und/oder die Elektrodenschicht (2) mit zumindest einer der deformierbaren Schichten (3) vernetzt sind/ist, **dadurch gekennzeichnet,**
**dass** das vernetzbare Material der deformierbaren Schichten (3) und/oder der Elektrodenschicht (2) strahlenvernetzbar, insbesondere UV- und/oder elektronenstrahlvernetzbar, ist.

2. Vielschichtaktor nach Anspruch 1, **dadurch gekennzeichnet,**
**dass** die deformierbaren Schichten (3) in einem Anlagebereich außerhalb der Elektrodenschicht (2) miteinander vernetzt sind.

3. Vielschichtaktor nach einem der Ansprüche 1 oder 2, **dadurch gekennzeichnet,**
**dass** die Elektrodenschicht (2) aus vernetzbarem, deformierbarem Material, vorzugsweise aus dem gleichen Material wie die deformierbaren Schichten (3), oder aus elektrisch leitfähigem Polymer ausgebildet ist.

4. Vielschichtaktor nach Anspruch 3, **dadurch gekennzeichnet,**
**dass** die Elektrodenschicht (2) in dem deformierbaren Material verteilte, elektrisch leitende Partikel, insbesondere Kohlenstoffpartikel, aufweist.

5. Vielschichtaktor nach einem der vorhergehenden Ansprüche, **dadurch gekennzeichnet,**
**dass** der Vielschichtaktor (1) in Stapeltechnik und/oder in Falttechnik und/oder in Sprüh- und/oder Drucktechnik realisiert ist.

6. Vielschichtaktor nach einem der vorhergehenden Ansprüche, **dadurch gekennzeichnet,**
**dass** die nebeneinander angeordneten Schichten (2, 3) in einer Hülle aus vernetzbarem, dielektrischem Material aufgenommen sind, wobei die Hülle mit den Schichten (2, 3) vernetzt ist.

7. Vielschichtaktor nach einem der vorhergehenden Ansprüche, **dadurch gekennzeichnet,**
**dass** der Vielschichtaktor (1) mehr als drei Schichten (2, 3) aufweist, wobei jeweils zwei aneinander angrenzende Schichten (2, 3) miteinander vernetzt sind.

8. Verfahren zum Herstellen eines Vielschichtaktors (1), insbesondere nach einem der vorhergehenden Ansprüche, wobei ein Schichtaufbau, umfassend eine zwischen zwei deformierbaren Schichten (3) aus einem vernetzbaren, dielektrischen Material, aufgenommene Elektrodenschicht (2) erzeugt wird, wobei die deformierbaren Schichten (3) miteinander und/oder die Elektrodenschicht (2) mit den deformierbaren Schichten (3) vernetzt werden/wird, **dadurch gekennzeichnet,**
**dass** die Schichtanordnung zum Vernetzen der deformierbaren Schichten (3) und/oder der Elektrodenschicht (2) mit den deformierbaren Schichten (3), insbesondere mit UV-Licht, bestrahlt wird.

9. Verfahren nach Anspruch 8, **dadurch gekennzeichnet,**
**dass** die deformierbaren Schichten (3) und/oder die Elektrodenschicht (2) vor dem Herstellen des Schichtaufbaus teilvernetzt werden.

10. Verfahren nach einem der Ansprüche 8 oder 9, **dadurch gekennzeichnet, dass** der Schichtaufbau in Stapeltechnik und/oder Falttechnik realisiert wird.

11. Verfahren nach Anspruch 8, **dadurch gekennzeichnet,**
**dass** die Schichtanordnung in Sprühtechnik und/oder in Drucktechnik realisiert wird, und nach dem Aufsprühen bzw. Aufdrucken einer, insbesondere jeder, Schicht (2, 3) eine Teilvernetzung durchgeführt wird.

## Claims

1. Multilayer actuator with at least one electrode layer (2), which is arranged between two deformable layers (3), comprising a dielectric, crosslinkable material, the deformable layers (3) being crosslinked with one another and/or the electrode layer (2) being crosslinked with at least one of the deformable layers (3), **characterized in that** the crosslinkable material of the deformable layers (3) and/or of the electrode layer (2) is radiation-crosslinkable, in particular crosslinkable by a UV and/or electron beam.

2. Multilayer actuator according to Claim 1, **characterized in that** the deformable layers (3) are crosslinked with one another in an attachment area outside the electrode layer (2).

3. Multilayer actuator according to either of Claims 1 and 2, **characterized in that** the electrode layer (2) is formed from crosslinkable, deformable material, preferably from the same material as the deformable layers (3) or from electrically conductive polymer.

4. Multilayer actuator according to Claim 3, **characterized in that** the electrode layer (2) has electrically conducting particles, in particular carbon particles, distributed in the deformable material.

5. Multilayer actuator according to one of the preceding claims, **characterized in that** the multilayer actuator (1) is realized by a stacking technique and/or by a folding technique and/or by a spraying and/or printing technique.

6. Multilayer actuator according to one of the preceding claims, **characterized in that** the layers (2, 3) arranged next to one another are accommodated in a shell of crosslinkable, dielectric material, the shell being crosslinked with the layers (2, 3).

7. Multilayer actuator according to one of the preceding claims, **characterized in that** the multilayer actuator (1) has more than three layers (2, 3), two respectively adjacent layers (2, 3) being crosslinked with one another.

8. Method for producing a multilayer actuator (1), in particular according to one of the preceding claims, a layer structure being created, comprising an electrode layer (2) accommodated between two deformable layers (3) of a crosslinkable, dielectric material, the deformable layers (3) being crosslinked with one another and/or the electrode layer (2) being crosslinked with the deformable layers (3), **characterized in that** the layer arrangement is irradiated, in particular with UV light, for crosslinking the deformable layers (3) and/or the electrode layer (2) with the deformable layers (3).

9. Method according to Claim 8, **characterized in that** the deformable layers (3) and/or the electrode layer (2) are partially crosslinked before the layer structure is produced.

10. Method according to either of Claims 8 and 9, **characterized in that** the layer structure is realized by a stacking technique and/or by a folding technique.

11. Method according to Claim 8, **characterized in that** the layer arrangement is realized by a spraying technique and/or by a printing technique, and a partial crosslinking is carried out after the spraying on or printing on of a layer, in particular of each layer (2, 3).

## Revendications

1. Actionneur multicouche avec au moins une couche d'électrode (2), qui est disposée entre deux couches déformables (3), comprenant un matériau diélectrique réticulable, dans lequel les couches déformables (3) sont réticulées l'une avec l'autre et/ou la couche d'électrode (2) est réticulée avec au moins une des couches déformables (3), **caractérisé en ce que** le matériau réticulable des couches déformables (3) et/ou de la couche d'électrode (2) est réticulable au moyen d'un rayonnement, en particulier d'un rayonnement UV et/ou d'un faisceau d'électrons.

2. Actionneur multicouche selon la revendication 1, **caractérisé en ce que** les couches déformables (3) sont réticulées l'une avec l'autre dans une zone d'appui à l'extérieur de la couche d'électrode (2).

3. Actionneur multicouche selon une des revendications 1 ou 2, **caractérisé en ce que** la couche d'électrode (2) est formée de matériau déformable, réticulable, de préférence du même matériau que les couches déformables (3), ou de polymère électriquement conducteur.

4. Actionneur multicouche selon la revendication 3, **caractérisé en ce que** la couche d'électrode (2) présente des particules électriquement conductrices, en particulier des particules de carbone, réparties dans le matériau déformable.

5. Actionneur multicouche selon l'une quelconque des revendications précédentes, **caractérisé en ce que** l'actionneur multicouche (1) est réalisé par la technique de l'empilement, et/ou par la technique du pliage et/ou par la technique de la pulvérisation et/ou de l'impression.

6. Actionneur multicouche selon l'une quelconque des revendications précédentes, **caractérisé en ce que** les couches juxtaposées (2, 3) sont logées dans une enveloppe en matériau diélectrique réticulable, l'enveloppe étant réticulée avec les couches (2, 3).

7. Actionneur multicouche selon l'une quelconque des revendications précédentes, **caractérisé en ce que** l'actionneur multicouche (1) présente plus que trois couches (2, 3), deux couches (2, 3) adjacentes l'une à l'autre étant chaque fois réticulées l'une avec l'autre.

8. Procédé de fabrication d'un actionneur multicouche (1) en particulier selon l'une quelconque des revendications précédentes, dans lequel on produit une structure stratifiée, comprenant une couche d'électrode (2) logée entre deux couches déformables (3) en un matériau diélectrique réticulable, dans lequel on réticule les couches déformables (3) l'une avec l'autre et/ou la couche d'électrode (2) avec les couches déformables (3), **caractérisé en ce que** l'on expose l'agencement de couches à un rayonnement, en particulier à une lumière UV, pour la réticulation des couches déformables (3) et/ou de la couche d'électrode (2) avec les couches déformables (3).

9. Procédé selon la revendication 8, **caractérisé en ce que** l'on réticule partiellement les couches déformables (3) et/ou la couche d'électrode (2) avant la fabrication de la structure stratifiée.

10. Procédé selon une des revendications 8 ou 9, **caractérisé en ce que** l'on réalise la structure stratifiée par la technique de l'empilement et/ou par la technique du pliage.

11. Procédé selon la revendication 8, **caractérisé en ce que** l'on réalise l'agencement de couches par la technique de la pulvérisation et/ou la technique de l'impression, et on effectue une réticulation partielle après la pulvérisation ou l'impression d'une, en particulier de chaque couche (2, 3).
